# EUROPEAN PATENT APPLICATION

(11) **EP 1 536 493 A2**
(43) Date of publication of application: **01.06.2005**
(21) Application number: 04028004.2
(22) Date of filing: 25.11.2004
(51) Int. Cl.: H01L 51/20

(54) **Light emitting device and method for producing the device**

(30) Priority: 25.11.2003 JP 2003393201
(71) Applicant: KABUSHIKI KAISHA TOYOTA JIDOSHOKKI, Kariya-shi, Aichi 448-8671 (JP)
(72) Inventor: Noritake, Kazuto, K.K. Toyota Jidoshokki, Kariya-shi Aichi (JP)
(74) Representative: Leson, Thomas Johannes Alois, Dipl.-Ing.

(57) **Abstract**

A light emitting device includes: a plurality of luminescent cells each having substantially same thickness and including a first and a second conductive layers having conductive characteristic and a light emitting layer being sandwiched by the first and the second conductive layers and including a luminescent material that emits light when a voltage is applied; a first electrode substrate being contacted with the first conductive layer of each of the luminescent cells to be electrically connected therewith; a second electrode substrate being contacted with the second conductive layer of each of the luminescent cells to be electrically connected therewith; and a sealing member that seals the luminescent cells within a space formed between the first and the second electrode substratess. The first electrode substrate and the first conductive layer are transparent with respect to the light emitted from the light emitting layer.

## Description

### BACKGROUND OF THE INVENTION

### Field of the Invention

The present invention relates to a novel structure of a light emitting device having a luminescent element, such as an organic electroluminescence element (hereinafter, occasionally referred to as an organic EL element) or an inorganic electroluminescence element (hereinafter, occasionally referred to as an inorganic EL element), and a method for producing a light emitting device having the novel structure.

### Description of the Related Art

A light emitting device having an organic EL element or an inorganic EL element (hereinafter, referred to as an organic EL light emitting device or an inorganic EL light emitting device, respectively) has conventionally been produced by accumulating, on a substrate, a first electrode, a layer containing a luminescent material and a second electrode in this order. A conventional method for producing such light emitting device is disclosed in a document cited below:
Gekkan Display (Monthly Display), December Extra Issue, "Organic EL Display - Kiso kara Saishin Gijutu (Fundamentals to Newest Technologies)", published by Techno Times, Co., Ltd. on December 20, 2001

However, growth in size of the light emitting device has not been always straightforward. For example, in a case where the size of the organic EL light emitting device is increased, an electric current cannot flow uniformly over the entire luminescent area, and there is an increasing possibility of fluctuating the brightness depending on positions, or forming a part liable to be deteriorated. Furthermore, a gas, such as oxygen and moisture, penetrates into the element during the production process or upon use, and there is an increasing possibility of deteriorating the positions where the gas penetrates to form non-light emitting parts. Therefore, the growth in size of the light emitting device brings about considerable decrease in yield and causes occurrence of defects.

### SUMMARY OF THE INVENTION

It is therefore one of objects of the invention to provide a light emitting device having a novel structure. Another object of the invention is to provide a method for producing the light emitting device.

According to a first aspect of the invention, there is provided a light emitting device including: a plurality of luminescent cells each having substantially same thickness and including a first and a second conductive layers having conductive characteristic and a light emitting layer being sandwiched by the first and the second conductive layers and including a luminescent material that emits light when a voltage is applied; a first electrode substrate being contacted with the first conductive layer of each of the luminescent cells to be electrically connected therewith; a second electrode substrate being contacted with the second conductive layer of each of the luminescent cells to be electrically connected therewith; and a sealing member that seals the luminescent cells within a space formed between the first and the second electrode substrates, wherein the first electrode substrate and the first conductive layer of each of the luminescent cells are transparent with respect to the light emitted from the light emitting layer.

According to a second aspect of the invention, there is provided a method for producing a light emitting device, the method including: producing a plurality of luminescent cells each having substantially same thickness and including a first and a second conductive layers having conductive characteristic and a light emitting layer being sandwiched by the first and the second conductive layers and including a luminescent material that emits light when a voltage is applied; arranging each of the luminescent cells on a first electrode substrate in a manner that the first conductive layer of each of the luminescent cells contacts with the first electrode substrate to be electrically connected therewith; disposing a second electrode on the luminescent cells in a manner that the second electrode contacts with the second conductive layer of each of the luminescent cells to be electrically connected therewith; and sealing the luminescent cells within a space formed between the first and the second electrode substrates, wherein the first electrode substrate and the first conductive layer of each of the luminescent cells are transparent with respect to the light emitted from the light emitting layer.

According to a third aspect of the invention, there is provided a method for producing a light emitting device, the method including: producing a plurality of luminescent cells each having substantially same thickness and including a first and a second conductive layers having conductive characteristic and a light emitting layer being sandwiched by the first and the second conductive layers and including a luminescent material that emits light when a voltage is applied; disposing a first and a second electrode substrates with a distance that substantially equals to the thickness of the luminescent cells to form a space therebetween; inserting the luminescent cells into the space in a manner that the first and the second conductive layers of each of the luminescent cells are respectively contacted with the first and the second electrode substrates to be electrically connected therewith, respectively; and sealing the luminescent cells within the space formed between the first and the second electrode substrates, wherein the first electrode substrate and the first conductive layer of each of the luminescent cells are transparent with respect to the light emitted from the light emitting layer.

### BRIEF DESCRIPTION OF THE DRAWINGS

The objects and advantages of the present invention will become more apparent by describing preferred exemplary embodiments thereof in detail with reference to the accompanying drawings, wherein:
Figs. 1A and 1B are schematic cross sectional views showing an organic EL light emitting device 10 and an organic EL cell 12, respectively, according to an embodiment of the invention;
Fig. 2 is a schematic cross sectional view showing a modified example of an organic EL light emitting device according to an embodiment of the invention;
Fig. 3 is a schematic cross sectional view showing another example of an organic EL light emitting device;
Fig. 4 is a schematic cross sectional view showing another example of an organic EL light emitting device;
Fig. 5 is a schematic cross sectional view showing another example of an organic EL light emitting device;
Fig. 6 is a schematic cross sectional view showing another example of an organic EL light emitting device;
Fig. 7 is a schematic cross sectional view showing another example of an organic EL light emitting device; and
Fig. 8 is a schematic cross sectional view showing another example of an organic EL light emitting device.

### DETAILED DESCRIPTION OF THE PREFERRED EMBODIMENTS

The light emitting device according to an embodiment of the invention will be described below with reference to an organic EL light emitting device as an example. The method for producing a light emitting device according to an embodiment of the invention will be also described below with reference to a method for producing an organic EL light emitting device as an example.

The drawings are not engineering drawings of an actual light emitting device but are diagrams for illustrating the structure thereof or schematic diagrams with plural dimensions being extremely modified for elicitation. In the drawings, the same or analogous structural members are attached to the same symbols.

The term "transparent" referred herein means that at least a part of light emitted from the layer containing a luminescent material is transmitted. For example, in a case where the layer emits light having plural wavelengths, a case where light of one or plural wavelengths is transmitted is referred by the term "transparent". The transmittance of a "transparent" member may be at least a value exceeding 0%, preferably exceeding 50%, and more preferably exceeding 70%. The transmittance may be different depending on wavelength or wavelength band.

An organic EL light emitting device according to this embodiment will be described, and a method for producing the device will be then described.

### <<Basic Configuration and Function of Organic EL Light Emitting Device 10>>

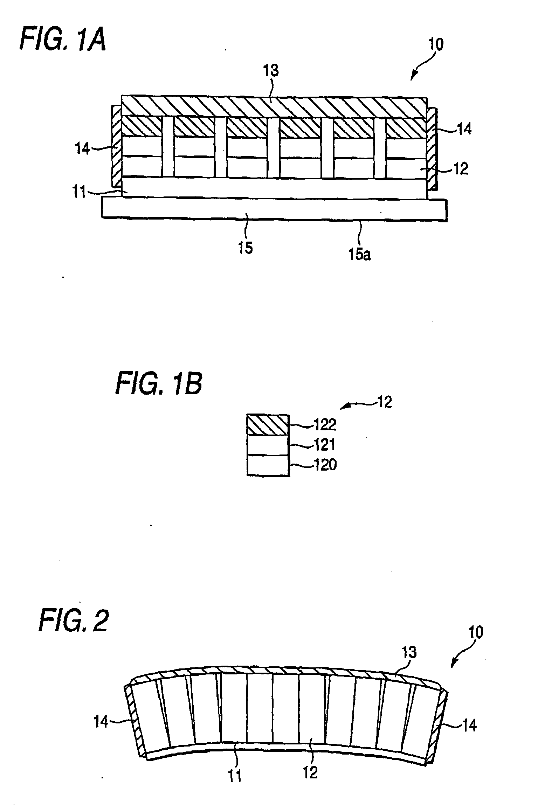

Fig. 1A is a schematic cross sectional view showing an organic EL light emitting device 10. As shown in Fig. 1A, the organic EL light emitting device 10 has a transparent substrate (a reinforcement substrate) 15 having a predetermined rigidity that is sufficient for supporting the whole structure of the organic EL light emitting device 10 and having provided thereon a transparent electrode (a first electrode substrate) 11. Plural organic EL cells (luminescent cells) 12 are disposed on the transparent electrode 11, and a back conductor (a second electrode substrate) 13 is further provided thereon. A protective film (sealing member) 14 is provided between ends of the transparent electrode 11 and the back electrode 13.

Fig. 1B is a schematic cross sectional view showing the organic EL cell 12. As shown in Fig. 1B, the organic EL cell 12 has a transparent conductor 120 and a back conductor (another conductor) 122 with an organic layer (a layer containing a luminescent material) 121 intervening therebetween. In the organic EL cell 12, the organic layer 121 emits light upon applying a voltage between the transparent conductor 120 and the back conductor 122. Accordingly, the organic EL cells 12 each constitutes an organic EL element.

The transparent electrode 11 and the back electrode 13 shown in Fig. 1A can be regarded as a chassis for supporting (retaining at prescribed positions by supporting) the organic EL cells 12.

In the organic EL light emitting device 10, the transparent electrode 11 and the back electrode 13 are connected to an external electric power source, and upon applying a voltage between the electrodes, positive holes and electrons are injected to the organic layer 121 through the transparent conductor 120 and the back conductor 122, respectively. Accordingly, the organic layers 121 of the respective organic EL cells generate light. The light thus generated is emitted to the exterior of the device through the transparent conductor 120, the transparent electrode 11 and the transparent substrate 15.

The ends of the transparent electrode 11 and the back electrode 13 are sealed with the protective film 14, and therefore, the interior (inner space) of the organic EL light emitting device 10 is protected from the exterior. The protective film 14 may have various functions, and preferably has at least a protective function of preventing (or suppressing) the exterior environment (particularly, oxygen and moisture) from penetrating into the interior of the device. According to the configuration, the organic EL cells 12 can be prevented from being deteriorated or modified. The protective film 14 preferably has a protective function of protecting the interior from an external pressure and a protective function of protecting the interior (i.e., the organic EL cells 12) from deterioration factors. In a case where the required protective function cannot be attained only by a single protective film, such a protective film may be used that is formed by accumulating plural protective films each attaining the respective functions.

### <<Advantages>>

Advantages obtained by the organic EL light emitting device 10 will now be described.
(1) A light emitting device can be constituted by an organic EL element (organic EL cell 12) having a small luminescent area.
   As having been described, the production of an organic EL element having a large luminescent area is substantially difficult, but the production of a small organic EL element is relatively easy in comparison to the production of a large organic EL element. Therefore, the yield upon production can be improved.
   Furthermore, an organic EL light emitting device having a large luminescent area can be produced, which has been substantially difficult to be produced by the conventional techniques.
(2) Electric current densities at positions over the luminescent area can be easily made substantially uniform.
   In a light emitting device, such as an organic EL light emitting device, the electric current density flowing in the luminescent area (organic layer) is liable to fluctuate in a case where the luminescent area is increased. A problem of uneven brightness occurs due to the fluctuation in electric current density. The problem is caused by such factors as difficulty in uniformity of the thickness of the organic layer and difficulty in uniformity of the compositional ratio thereof (for example, a mixing ratio of a dopant to a host), which are brought about by the large area of the organic layer. Due to these factors, it is difficult that the electric current densities at positions over the luminescent area are made substantially uniform.
   On the other hand, the organic EL light emitting device 10 does not have a luminescent area integrally formed but has a luminescent area that is constituted by accumulating small organic EL cells 12 each having a small luminescent area. The production of an organic EL element having a small luminescent area (i.e., the organic EL cell 12) is practically easy in comparison to the production of an organic EL element having a large luminescent area, and thus the aforementioned problems are difficult to occur, as having been described. Therefore, the electric current densities at positions over the luminescent area can be easily made substantially uniform in comparison to an organic EL element having the same luminescent area by itself.
   Furthermore, even in a case where the electric current densities within the luminescent area of the organic EL cell 12 are not substantially uniform, the luminescent area of the organic EL cell 12 constitutes merely a part of the luminescent area of the organic EL light emitting device 10, and therefore, the electric densities at positions over the entire luminescent area of the organic EL light emitting device 10 can be substantially uniform. Accordingly, the problems of uneven brightness and so on can be prevented from occurring to such a level that cannot be visually recognized.
(3) The light extraction efficiency can be improved in comparison to the conventional organic EL element.

The organic EL light emitting device 10 may contain a part having a different refractive index, which does not occur in an organic EL element having the same luminescent area. For example, there are such cases that a space is formed between the organic EL cells 12, at least one of the organic EL cell 12 has a layer structure that is different from that of the other organic EL cells 12, and a part or a plurality of the materials of the organic EL cells 12 is different from the others. In the case where the organic EL light emitting device 10 contains a part having a refractive index that is different from that of the organic EL cells 12, the traveling direction of light emitted from the organic EL cells 12 to directions that cannot enter into the transparent electrode 11 can be changed with respect to a light emitting surface 15a to thereby allowing the light to enter into the transparent electrode 11. Specifically, the ordinary organic EL element involves such light that is emitted in the transversal direction from the organic layer to decay through guiding in the organic layer or to travel toward the exterior through an end of the organic layer, but in the organic EL light emitting device 10, a part or the whole of the light can be made incident on the transparent electrode 11. Accordingly, the light extraction efficiency can be improved in comparison to the ordinary organic EL element.

The traveling direction of light referred in the invention means the minimum angle among angles formed between a plane that is substantially parallel to the light emitting surface 15a and the traveling direction (straight line) of light. More specifically, a straight line perpendicular to the plane is drawn from the straight line formed by the traveling direction of the light, and a straight line is drawn from an intersecting point of the plane and the perpendicular line to an intersecting point of the plane and the straight line formed by the traveling direction of the light. The traveling direction of light is defined as an angle formed between the straight line connecting the intersecting points and the aforementioned traveling direction of light.

A production example of the organic EL light emitting device 10 will be described.

### <<Production Example of Organic EL Light Emitting Device 10>>

The organic EL light emitting device 10 having the aforementioned configuration can be produced by appropriately utilizing a known production process of an organic EL light emitting device. Specific examples of the production process will be described below, but the following production examples are mere examples, and the invention is not construed as being limited thereto.

### <First production example>

In a first production example, organic EL cells 12 are disposed on an electrode substrate, and another electrode substrate is disposed on the cell.

The production process contains the following steps.
(a) Organic EL cells 12 are produced.
   In this step, an organic layer 121 may be provided between a transparent conductor 120 and a back conductor 122 according to a known production process of an organic EL element to produce the organic EL cells 12. The thickness of the organic EL cells 12 is substantially the same as each other.
(b) The organic EL cells 12 are disposed on a transparent electrode 11 or a back electrode 13.
   The organic EL cells 12 are arranged on, for example, a back conductor (electrode substrate) 13 in such a manner that the back conductor 11 of the organic EL cell 12 faces downward.
   In a case where the transparent electrode 11 is used as the electrode substrate, in general, a transparent electrode 11 is provided on a transparent substrate 15 to form an electrode substrate, and the organic EL cells 12 are arranged on the transparent electrode 11 in such a manner that the transparent conductor 120 faces downward, as shown in Fig. 1A.
   In other words, all the organic EL cells 12 are disposed on the electrode substrate to make the transparent conductors 120 thereof directed to the same direction.
(c) An electrode substrate different from the aforementioned electrode substrate is disposed on the organic EL cells 12.
   In a case where the organic EL cells 12 are arranged on the back electrode 13, the transparent electrode (electrode substrate) 11 is disposed on the organic EL cells 12. In alternative, as having been described, the electrode substrate containing the transparent substrate 15 having formed on one surface thereof the transparent electrode 11 may be disposed to face the transparent electrode 11 downward (i.e., facing the back electrode 13).
(d) An area between ends of the electrode substrates is sealed.
   A protective film 14 is provided for protecting an interior of the organic EL light emitting device 10, more specifically, an area between the transparent electrode 11 and the back electrode 13.
   Practicing the aforementioned steps, the organic EL light emitting device 10 shown in Fig. 1A can be produced.

### <Second Production Example>

Hereinafter, a second production example will be described. In the following Production Examples, the step (b) is changed among the aforementioned steps (a) to (d).

In the second production example, organic EL cells 12 are disposed by using a magnetic force.

An organic EL light emitting device 10 can be produced in the same manner as in the first production example except that the step (b) is changed as follows.

In a case where the second production example is practiced, it is necessary that an electrode substrate, on which organic EL cells 12 are arranged, is formed with a non-magnetic material, and the conductor (120 or 122) of the organic EL cells 12 connecting to the electrode substrate is formed with a magnetic material.

For example, in a case where the organic EL cells 12 are arranged on the back electrode 13, the back electrode 13 is formed with a non-magnetic material, and the back conductor 122 is formed with a magnetic material. A permanent magnet or an electromagnet is disposed in such a manner that the back conductor 122 of the organic EL cell 12 is attracted to the back electrode 13. Upon arranging the organic EL cells 12 in this manner, the organic EL cells 12 are disposed at a position with a certain distance from the back electrode 13, and then the organic EL cells 12 are attracted to the back electrode 13 by a magnetic force, whereby the organic EL cells 12 can be arranged on the back electrode 13 to make the back conductor 122 directed to the back electrode 13.

The organic EL cells 12 can also be arranged on the transparent electrode 11 by using the aforementioned technique.

In the second production example, the conductor (120 or 122) of the organic EL cells 12 connecting to the electrode substrate is formed with a magnetic material. However, the organic EL cells 12 may be configured to have a magnetic layer separately formed thereon in order to arrange on the back electrode 13 or on the transparent electrode 11 by the magnetic force.

### <Third production example>

Hereinafter, a third production example will be described.

In the third production example, organic EL cells 12 are disposed by using a magnetic force as similar to the second production example.

An organic EL light emitting device 10 can be produced in the same manner as in the first production example except that the step (b) is changed as follows.

In the third production example, it is necessary, as similar to the second production example, that an electrode substrate, on which organic EL cells 12 are arranged, is formed with a non-magnetic material, and the conductor (120 or 122) of the organic EL cells 12 connecting to the electrode substrate is formed with a magnetic material.

For example, in a case where the organic EL cells 12 are arranged on the back electrode 13, the back electrode 13 is formed with a non-magnetic material, and the back conductor 122 is formed with a magnetic material. One or a plurality of the organic EL cells 12 are disposed on the back electrode 13 in such a manner that the back conductor 122 faces downward. A permanent magnet or an electromagnet is moved on the back side of the back electrode 13 (i.e., the side not in contact with the organic EL cells 12), so as to arrange the organic EL cells 12 at prescribed positions on the back electrode 13. All the organic EL cells 12 can be arranged at prescribed positions on the back electrode 13 by repeating the aforementioned operation.

Upon arranging the organic EL cells 12 on the back electrode 13, the operation of making the back conductor 122 in contact with the back electrode 13 (i.e., arranging the organic EL cells 12 on the back electrode 13 in such a manner that the back conductor 122 faces downward) can be easily carried out by using a magnetic force as similar to the second production example.

The organic EL cells 12 can also be arranged on the transparent electrode 11 by using the aforementioned technique.

### <Fourth production example>

Hereinafter, a fourth production example will be described.

In the fourth production example, organic EL cells 12 are previously arranged in the same direction and then arranged on an electrode substrate.

An organic EL light emitting device 10 can be produced in the same manner as in the first production example except that the step (b) is changed as follows.

In the fourth production example, the organic EL cells 12 are arranged on a retaining member in such a manner that the back conductor 122 or the transparent conductor 120 is in contact with the retaining member (i.e., faces downward). Upon arranging in this manner, the organic EL cells 12 are adhered to the retaining member, for example, with a volatile adhesive. The organic EL cells 12 may also be adhered by a magnetic force as similar to the aforementioned production examples.

The side of the retaining member, on which the organic EL cells 12 are provided, is made face a transparent electrode 11 or a back electrode 13, and then the adhesive is evaporated to arrange the organic EL cells 12 on the transparent electrode 11 or the back electrode 13.

### <Fifth production example>

Hereinafter, a fifth production example will be described.

In the fifth production example, a chassis having a transparent electrode 11 and a back electrode 13 facing each other is produced, and organic EL cells 12 are arranged in the chassis.

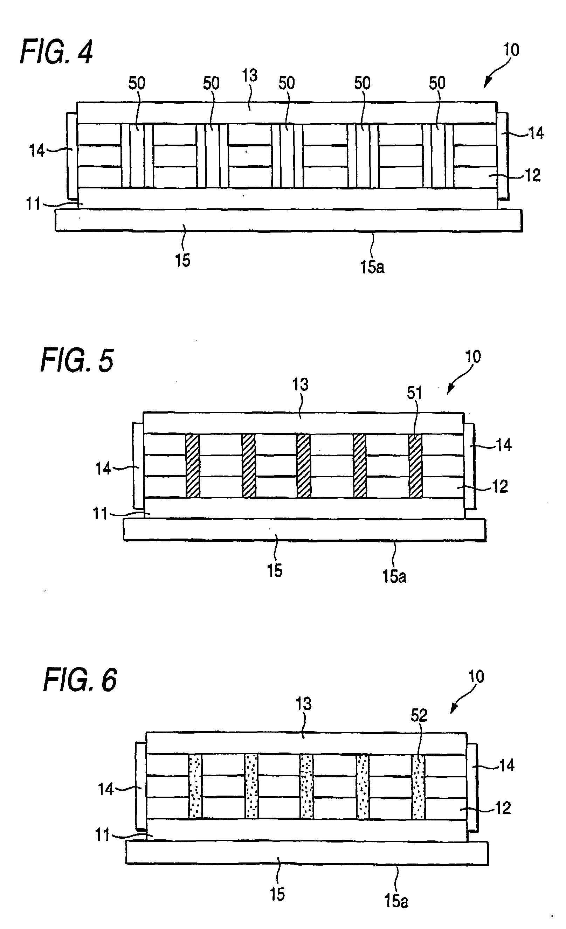

In the fifth production example, as shown in Fig. 4, a transparent electrode 11 and a back electrode 13 are disposed with a predetermined distance therebetween by using one or plural supporting members 50 to form a chassis, and organic EL cells 12 are inserted into the chassis. A specific example of the production example will be described below with reference to steps constituting the process.

### (a') A chassis is produced.

A transparent electrode 11 (or a transparent electrode 11 formed on a transparent substrate 15) and a back electrode 13 are disposed with a certain distance therebetween by using one or plural supporting members to form a chassis.

The supporting member may be formed with any material, which is preferably such a material that does not render degradation and deterioration to the organic EL cells 12, the transparent electrode 11 and the back electrode 13. The supporting member may be fixed to the transparent electrode 11 and/or the back electrode 13, and may be a movable supporting member, such as a spherical supporting member. Furthermore, the supporting member may be detached before sealing ends of the chassis with a sealing member in the step (d') described later. In a case where the supporting member is not detached, the supporting member preferably has a size (or a diameter) that is difficult to be recognized upon viewing the supporting member in the normal line direction of the transparent substrates 13, 15 (which is generally a size of about 100 µm).

### (b') Organic EL cells 12 are produced.

The organic EL cells 12 may be produced in the same manner as in the aforementioned step (a). The thickness of the organic EL cells 12, i.e., the distance from the surface of the transparent conductor 120 opposite to the surface in contact with the organic layer 121 to the surface of the back conductor 122 opposite to the surface in contact with the organic layer 121, is substantially the same as the distance between the transparent electrode 11 and the back electrode 13 in the chassis. The production process of the organic EL cells 12 will be described later in more detail.

### (c') The organic EL cells 12 are inserted into the chassis.

The organic EL cells 12 are inserted into the chassis produced in the aforementioned step (a') in such a manner that the transparent electrode 11 is in contact with the transparent conductor 120, and the back electrode 13 is in contact with the back conductor 122.

### (d') Ends of the chassis (i.e., the transparent electrode 11 and the back electrode 13) are protected.

A protective film 14 is provided between the ends of the chassis, i.e., the ends of the transparent electrode 11 and the back electrode 13. Consequently, the organic EL light emitting device 10 shown in Fig. 1A is completed.

As having been described, the term "chassis" referred herein means not only an assembly constituted by a transparent electrode 11 and a back electrode 13 as in this production example, but also a pair of a transparent electrode 11 and a back electrode 13 as in the first to fourth production examples.

### <Sixth production example>

Hereinafter, a sixth production example will be described.

The sixth production example contains the same steps as in the fifth production example except that the organic EL cells 12 are arranged by a magnetic force.

In the sixth production example, the organic EL light emitting device 10 may be produced in the same manner as in the fifth production example except that, in the step (c'), the organic EL cells 12 are arranged by using a magnetic force. This step will be described in detail below. In a case where the step is employed, at least one of the transparent electrode 11 and the back electrode 13 is formed with a non-magnetic material, and a conductor (the transparent conductor 120 or the back conductor 122) corresponding to the electrode is formed with a magnetic material.

In this production example, a permanent magnet is used upon inserting the organic EL cells 12 into the chassis and arranging them at prescribed positions. Specifically, after inserting the organic EL cells 12 into the chassis, one or plural cells are moved to the prescribed positions with the aforementioned magnet from the back side (outside) of the electrode formed with a non-magnetic material. According to the procedure, the organic EL cells 12 can be arranged extremely precisely at the prescribed positions.

In a case where the supporting member is formed with a magnetic material and is not fixed to both the electrodes (11 and 13), and both the conductors (120 and 122) of the organic EL cell 12 are formed with a non-magnetic material, the supporting member can be taken out from the chassis after inserting the organic EL cells 12 into the chassis.

In summary, the organic EL light emitting device 10 can be produced by the following steps (a1) to (d1).
(a1) An organic layer 121 is held between a pair of conductors 120 and 122, where at least one conductor 120 is transparent, to form plural organic EL cells 12 having the same thickness.
(b1) The organic EL cells 12 are arranged on a transparent electrode 11 (or a transparent electrode 11 formed on a transparent substrate 15) as a first electrode substrate in such a manner that the organic EL cells 12 are aligned in the same direction, i.e., the transparent conductor 120 is on the lower side.
(c1) A back electrode 13 as a second electrode substrate is disposed on the back conductors 122 of the organic EL cells 12 to be in contact with the back conductors 122.
(d1) An area between ends of the transparent electrode 11 and the back electrode 13 is sealed by the sealing member.

The organic EL cells 12 may also be arranged on the back conductor. In this case, the organic EL light emitting device 10 can be produced by the following steps (a2) to (d2).
(a2) An organic layer 121 is held between a pair of conductors 120 and 122, where at least one conductor 120 is transparent, to form plural organic EL cells 12 having the same thickness.
(b2) The organic EL cells 12 are arranged on a back electrode 13 as a first electrode substrate in such a manner that the organic EL cells 12 are aligned in the same direction, i.e., the back conductor 122 is on the lower side.
(c2) A transparent electrode 11 (or a transparent electrode 11 formed on a transparent substrate) as a second electrode substrate is disposed on the transparent conductor 120 of the organic EL cells 12 to be in contact with each of the transparent conductors 120.
(d2) An area between ends of the transparent electrode 11 and the back electrode 13 is sealed by the sealing member.

The organic EL light emitting device 10 can be produced by inserting organic EL cells 12 into a skeleton, i.e., a chassis, of the organic EL light emitting device 10 constituted by a transparent electrode 11 and a back electrode 13. In this case, the organic EL light emitting device 10 can be produced by the following steps (a3) to (d3).
(a3) A transparent electrode 11 and a back electrode 13 as another electrode are disposed with a prescribed distance therebetween to form a chassis.
(b3) An organic layer 121 is held between a transparent conductor 120 and a back conductor 122 as another conductor to form plural organic EL cells 12 having a thickness substantially the same as the prescribed distance.
(c3) The organic EL cells 12 are arranged in the chassis in such a manner that the transparent electrode 11 is in contact with the transparent conductor 120, and the back electrode 13 is in contact with the back conductor 122.
(d3) An area between ends of the transparent electrode 11 and the back electrode 13 is sealed by the sealing member.

The organic EL cells 12 may be arranged by using a magnetic force as described above. In this case, it is necessary that the transparent electrode 11 and/or the back electrode 13 is a non-magnetic body, and the transparent conductor 120 or the back conductor 122 of the organic EL cell 12 is a magnetic body. According to the configuration, the conductor as a magnetic body can be moved by a magnetic force, and therefore, the organic EL cells 12 can be arranged by a magnetic force.

A production example of the organic EL cell 12 will be described below.

### <<Production example of Organic EL Cell 12>>

The organic EL cell 12 can be produced according to a known production process of an organic EL element. For example, an organic layer 121 and a back conductor 122 may be accumulated on a transparent conductor 120 in this order according to a known production process of an organic EL element to produce the organic EL cells 12. In alternative, an organic layer 121 and a transparent conductor 120 may be accumulated on a back conductor 122 in this order.

It is also possible that an organic EL element having a luminescent area larger than the luminescent area of the organic EL cell 12 is produced as an organic EL element precursor (luminescent cell precursor) according to a known production process of an organic EL element, and the element is cut in a thickness direction thereof by cutting means, such as laser and a cutter, to produce the organic EL cells 12. The area of the luminescent area can be defined as an area in which the organic layer 121 and the pair of conductors (the transparent conductor 120 and the back conductor 122) overlap with each other.

In a case where the organic EL cells 12 thus produced are arranged at random within the organic EL light emitting device 10, even though the organic EL element has unevenness in electric current density flowing in the luminescent area, the area having the unevenness can be uniformly dispersed over the luminescent area of the organic EL light emitting device 10, whereby the problem of uneven brightness can be substantially reduced. In other words, even though such an organic EL element is used, that is determined as a defective product due to uneven brightness, the element is divided into plural cells, which are arranged at random, whereby such a device can be completed that has substantially the same electric current density over the luminescent area thereof. Accordingly, the organic EL element may be produced without extreme exactitude, and the production process can be simplified.

Furthermore, in a case where the organic EL cells 12 are obtained by cutting a region having a prescribed capability in the organic EL element, the problem of uneven brightness can be further reduced, in addition to the aforementioned effects.

The elements of the organic EL light emitting device 10 will be described in more detail. The transparent electrode 11 and the transparent conductor 120 are described together, and the back electrode 13 and the back conductor 122 are also described together.

### <<Detailed description of each of the elements>>

### <Transparent Electrode 11, Transparent conductor 120, Back electrode 13 and Back conductor 122>

One of the transparent electrode 11 and the back electrode 13 functions as an anode, and the other functions as a cathode. The transparent conductor 120 and the back conductor 122 are produced corresponding to the functions of the transparent electrode 11 and the back electrode 13 (i.e., the function as an anode and the function as a cathode), respectively. For example, in a case where the transparent electrode 11 functions as an anode, the transparent conductor 120 is also produced by using a transparent material for forming an anode. The electrodes and the conductors are described below in terms of the classification of an anode and a cathode.

An anode is an electrode that injects positive holes into the organic layer 121.

A material for forming an anode may be such a material that imparts the aforementioned property to an anode. Examples of the material include a known material, such as a metal, an alloy, an electroconductive compound and a mixture thereof, and the anode is produced to have a work function of 4 eV or more at a plane (surface) in contact with the anode.

Specific examples of the material for forming an anode include a metallic oxide and a metallic nitride, such as ITO (indium-tin oxide), IZO (indium-zinc oxide), tin oxide, zinc oxide, zinc-aluminum oxide and titanium nitride, a metal, such as gold, platinum, silver, copper, aluminum, nickel, cobalt, lead, chromium, molybdenum, tungsten, tantalum and niobium, an alloy, such as alloys of the metals and copper iodide, and an electroconductive polymer, such as polyaniline, polythiophene, polypyrrole, polyphenylenevinylene, poly(3-methylthiophene) and polyphenylene sulfide.

In a case where the transparent electrode 11 (and the transparent conductor 120) is used as an anode, the transmittance of light to be extracted is generally set at 10% or more. In a case where light in the visible region is extracted, ITO having a high transmittance in the visible region is preferably used.

In a case where the back electrode 13 (and the back conductor 122) is used as an anode, a reflective electrode is preferably used. In this case, such a material that has a capability of reflecting light to be exteriorly extracted is appropriately selected from the aforementioned materials, and in general, a metal, an alloy and a metallic compound are selected.

Furthermore, in order to prevent contrasting and to prevent reflection of external light, the back electrode 13 (and the back conductor 122) may have an absorption capability. In order to impart an absorption capability to the back electrode 13 (and the back conductor 122), such a material that exerts an absorption capability upon forming into an electrode is appropriately selected from the aforementioned materials.

The anode may be produced by using only one kind of the aforementioned materials and may be produced by using a mixture of plural kinds thereof. The anode may have a uniform composition and may have a multi-layer structure containing plural layers having different compositions.

The thickness of the anode is generally from 5 nm to 1 µm, preferably from 10 nm to 1 µm, more preferably from 10 nm to 500 nm, particularly preferably from 10 nm to 300 nm, and desirably from 10 nm to 200 nm, while it depends on the material used.

The thickness of the conductor is not particularly limited because the function of the electrode is mainly borne by the transparent electrode 11 and the back electrode 13.

The anode can be formed by using the aforementioned material by a known thin film forming method, such as a sputtering method, an ion plating method, a vacuum deposition method, a spin coating method and an electron beam deposition method.

The anode preferably has a sheet resistance of several hundreds Ω per unit area or less, and more preferably about from 5 Ω to 50 Ω per unit area.

The surface of the anode may be subjected to UV ozone cleaning or plasma cleaning.

In order to suppress short circuits and defects of the organic EL element from occurring, the surface roughness of the anode is controlled to be 20 nm or less in terms of root mean square by such a method as a method of reducing the particle diameter and a method of polishing after forming the film.

A cathode is an electrode that injects electrons into the organic layer 121.

Examples of a material for forming a cathode include a metal, an alloy, an electroconductive compound and a mixture thereof, for example, less than 4.5eV, generally having a work function of 4.0 eV or less, and typically 3.7 eV or less, for improving the electron injection efficiency.

Specific examples of the material for the electrode include lithium, sodium, magnesium, gold, silver, copper, aluminum, indium, calcium, tin, ruthenium, titanium, manganese, chromium, yttrium, an aluminum-calcium alloy, an aluminum-lithium alloy, an aluminum-magnesium alloy, a magnesium-silver alloy, a magnesium-indium alloy, a lithium-indium alloy, a sodium-calcium alloy, a magnesium-copper mixture, and an aluminum-aluminum oxide mixture. Materials used as an anode may also be used.

In a case where the back electrode 13 (and the back conductor 122) is used as a cathode, the material having a capability of reflecting light to be exteriorly extracted is appropriately from the aforementioned materials, and in general, a metal, an alloy and a metallic compound are selected.

In a case where the transparent electrode 11 (and the transparent conductor 120) is used as a cathode, it is generally set to have a transmittance to light to be extracted exceeding 10%, and for example, such an electrode is employed that is formed by accumulating a ultra-thin film of a magnesium-silver alloy and a transparent electroconductive oxide. In order to prevent the luminescent layer from being damaged by plasma upon sputtering an electroconductive oxide on the cathode, a buffer layer having copper phthalocyanine added thereto may be provided between the transparent conductor 120 and the organic layer 121.

The cathode may be produced by using only one kind of the aforementioned materials and may be produced by using plural kinds thereof. For example, the cathode can be prevented from being oxidized and can be improved in adhesiveness to the conductor and the organic layer 121 by adding from 5% to 10% of silver or copper to magnesium.

The cathode may have a uniform composition and may have a multi-layer structure containing plural layers having different compositions. The cathode may also have, for example, the following structures.

In order to prevent the cathode from being oxidized, a protective layer formed with a metal having corrosion resistance may be provided on such a part of the conductor that is not in contact with the organic layer 121.

As a material for the protective layer, for example, silver and aluminum are preferably used.

In order to reduce the work function of the cathode, an oxide, a fluoride, a metallic compound or the like having a small work function may be inserted at an interface between the conductor and the organic layer 121.

For example, a cathode formed with aluminum is used, and lithium fluoride or lithium oxide may be inserted at the interface.

The cathode can be formed by a known thin film forming method, such as a vacuum deposition method, a sputtering method, an ionization deposition method, an ion plating method and an electron beam deposition method.

The cathode preferably has a sheet resistance of several hundreds Ω per unit area or less.

### <Organic Layer 121>

The organic layer 121 is provided between the transparent conductor 120 and the back conductor 122. The organic layer 121 contains an organic luminescent material that emits light upon a voltage being applied between both the electrodes. The organic layer 121 may be a layer having a known layer structure and formed with a known material, and can be produced by a known production process.

The organic layer 121 realizes at least the following functions, which may be borne by plural layers of an accumulated structure, respectively, or may be attained by a sole layer.
(i) Electron injection function (electron injection property).
   Electrons are injected from the electrode (cathode).
(ii) Positive hole injection function (positive hole injection property)
   Positive holes are injected from the electrode (anode).
(iii) Carrier transporting function (carrier transporting property)
   At least one kind of electrons and positive holes is transported. The function of transporting electrons is referred to as an electron transporting function (electron transporting property), and the function of transporting positive holes is referred to as a positive hole transporting function (positive hole transporting property).
(iv) Luminescent function

Excitons are generated (i.e., an excited state is formed) by recombination of the electrons and the positive holes thus injected and transported, and light is emitted upon returning to the ground state.

In a case where the transparent conductor 120 is used as an anode, the organic layer 121 may be constituted by accumulating a positive hole injection and transporting layer, a luminescent layer and an electron injection and transporting layer, in this order from the transparent conductor 120.

The positive hole injection and transporting layer is such a layer that transports positive holes from the anode to the luminescent layer. Examples of a material for forming the positive hole transporting layer include a small molecular material, such as a metallic phthalocyanine compound, e.g., copper phthalocyanine and tetra(t-butyl)copper phthalocyanine, a non-metallic phthalocyanine compound, a quinacridone compound, and an aromatic amine compound, e.g., 1,1-bis(4-di-p-tolylaminophenyl)cyclohexane, N,N'-diphenyl-N,N'-bis(3-methylphenyl)-1,1'-biphenyl-4,4'-diamine and N,N'-di(1-naphthyl)-N,N'-diphenyl-1,1'-biphenyl-4,4'-diamine, a polymer compound, such as polythiophene and polyaniline, a polythiophene oligomer material, and other positive hole transporting materials having been known in the art.

The luminescent layer is such a layer that can be an excited state by recombination of positive holes transported from the anode and electrons transported from the cathode, and can emit light by returning from the excited state to the ground state. As a material for the luminescent layer, a fluorescent material and a phosphorescent material may be used. A dopant (a fluorescent material and a phosphorescent material) may be contained in a host material.

Examples of the material for forming the luminescent layer include a small molecular material, such as a 9,10-diarylanthracene derivative, a pyrene derivative, a coronene derivative, a perylene derivative, a rubrene derivative, 1,1,4,4-tetraphenylbutadiene, a tris(8-quinolinolate) aluminum complex, a tris(4-methyl-8-quinolinolate) aluminum complex, a bis(8-quinolinolate) zinc complex, a tris(4-methyl-5-trifluoromethyl-8-quinolinolate) aluminum complex, a tris(4-methyl"5-cyano-8-quinolinolate) aluminum complex, a bis(2-methyl-5-trifluoromethyl-8-quinolinolate) (4-(4-cyanophenyl)phenolate) aluminum complex, a bis(2-methyl-5-cyano-8-quinolinolate) (4-(4-cyanophenyl)phenolate) aluminum complex, a tris(8-quinolinolate) scandium complex, a bis(8-(p-tosyl)aminoquinoline) zinc or cadmium complex, 1,2,3,4-tetraphneylcyclopentadiene, pentaphenylcyclopentadiene, poly-2,5-diheptyloxy-p-pheneylene vinylene, a coumarin fluorescent material, a perylene fluorescent material, a pyran fluorescent material, an anthrone fluorescent material, a porphyrin fluorescent material, a quinacridone fluorescent material, an N,N'-dialkyl-substituted quinacridone fluorescent material, a naphthalimide fluorescent material and an N,N'-diaryl-substituted pyrrolopyrrole fluorescent material, a polymer material, such as polyfluorene, poly-p-phenylene vinylene and polythiophene, and other luminescent materials having been known in the art. In a case where the host/guest structure is employed, the host and the guest (dopant) may be appropriately selected from the aforementioned materials.

The electron injection and transporting layer is such a layer that transports electrons from the cathode (the back conductor 122 in this embodiment) to the luminescent layer. Examples of a material for forming the electron transporting layer include 2-(4-biphenylyl)-5-(4-t-butylphenyl)-1,3,4-oxadiazole, 2,5-bis(1-naphthyl)-1,3,4-oxadiazole and a derivative thereof, bis(10-hydroxybenzo [h]-quinolinolate) beryllium complex, and a triazole compound.

The organic layer 121 may have such a layer that can be employed in a known organic electroluminescent layer, such as a buffer layer, a positive hole blocking layer, an electron injection layer and a positive hole injection layer. These layers may be provided by using known materials according to a known production process. For example, the electron injection and transporting layer may be divided in terms functions into an electron injection layer bearing the electron injection function and an electron transporting layer bearing the electron transporting function, which are accumulated on each other. The materials for constituting the layers may be appropriately selected from known materials, and can be selected from the aforementioned materials for forming the electron injection and transporting layer.

### <Protective Layer (Sealing member) 14>

The sealing member 14 is provided at least between an end of the transparent electrode 11 and an end of the back electrode 13 for protecting the organic EL cells 12 and the like from the exterior. In general, an area between the ends of the electrodes is sealed with a passivation film (sealing film). Other parts than the area between the ends of the electrodes may also be protected, and in this case, a sealing may be used.

The passivation film is provided for preventing the organic EL cell 12 from being in contact with oxygen or moisture. The passivation film may also have a function of protecting from an external force and change in temperature. Examples of a material used as the passivation film include an organic polymer material, an inorganic material and a photocuring resin, and the material used as the sealing member may be used solely or in combination of two or more kinds thereof. The sealing member may have a single layer structure or a multi-layer structure. The passivation film may have such a thickness that can block moisture and gases from the exterior.

Examples of the polymer material include a fluorine resin, such as a chlorotrifluoroethylene polymer, a dichlorodifluoroethyelne polymer and a chlorotrifluoroethylene-dichlorodifluoroethylene copolymer, an acrylic resin, such as polymethyl methacrylate and polyacrylate, an epoxy resin, a silicone resin, an epoxy-silicone resin, a polystyrene resin, a polyester resin, a polycarbonate resin, a polyamide resin, a polyimide resin, a polyamideimide resin, a poly-p-xylene resin, a polyethylene resin and a polyphenylene oxide resin.

Examples of the inorganic material include polysilazane, a diamond thin film, amorphous silica, electroinsulative glass, a metallic oxide, a metallic nitride, a metallic carbide and a metallic sulfide.

The sealing can is a member for blocking moisture and oxygen from the exterior, which is constituted by a sealing member, such as a sealing plate and a sealing container. The sealing can may be provided only on the side of the back electrode 13 (the side opposite to the substrate 15) or may be provided to cover the entire organic EL light emitting device 10. The shape, size and thickness of the sealing member are not particularly limited as far as the thickness thereof is sufficient for sealing the organic EL light emitting device 10 and blocking the external air. Examples of a material used for the sealing member include glass, stainless steel, a metal (such as aluminum), plastics (such as polychlorotrifluoroethylene, polyester and polycarbonate), and ceramics.

Upon providing the sealing member in the organic EL light emitting device 10, a sealing agent (adhesive agent) may be appropriately used. In a case where sealing members cover the entire organic EL light emitting device 10, the sealing members may be fused to each other under heat using no sealing agent. Examples of the sealing agent include an ultraviolet curing resin, a thermosetting resin and a two-component curing resin.

In a case where the intended protective function cannot be realized with only one passivation film or sealing can, the sealing member 14 may have an accumulated structure of plural passivation films each attaining the respective functions. For example, a sealing member capable of protecting the cells in the device from external pressure may be provided, and another sealing member capable of protecting from external atmosphere (moisture and oxygen) may also be provided in combination. A known sealing member with a single layer structure having both functions may be used.

### <Transparent Substrate 15>

The transparent substrate 15 is a member mainly having a plate form for supporting the transparent electrode 11.

Known materials may be used for the transparent substrate 15. In general, a glass substrate, a silicon substrate, a ceramics substrate such as a quartz substrate, and a plastics substrate are used. A substrate formed with a complex sheet having a combination of the same kind or different kinds of substrates.

Modified examples of the embodiment of the invention will be described.

### <<Modified Examples>>

The organic EL light emitting device 10 may have the aforementioned modified examples and the following modified examples, and the use of the modified examples renders functions and effects derived therefrom to the organic EL light emitting device 10. The modified examples may be combined unless they contradict each other.

### <Moisture Absorbent inserted into Chassis>

As shown in Fig. 5, a moisture absorbent 51 may be inserted into the chassis. The moisture absorbent 51 is not particularly limited, and specific examples thereof include barium oxide, sodium oxide, potassium oxide, calcium oxide, sodium sulfate, calcium sulfate, magnesium sulfate, phosphorous pentoxide, calcium chloride, magnesium chloride, copper chloride, cesium fluoride, niobium fluoride, calcium bromide, vanadium bromide, molecular sieve, zeolite and magnesium oxide.

### <Gas inert to Organic EL Cells 12 filled in Chassis>

As shown in Fig. 6, the interior of the chassis may be filled with a gas 52 that is inert to the organic EL cells 12 and the electrodes, and may be a vacuum atmosphere. The inert gas referred herein means such a gas that does not react with the organic EL cells 12 and the like, and examples thereof include a rare gas such as helium and argon, and a nitrogen gas.

### <Configuration with no Transparent Substrate 15>

The transparent substrate 15 may not be provided. In a case where the transparent substrate 15 is not provided, it is preferred that the surface of the transparent electrode 11 is protected with the aforementioned sealing member or the like to prevent the surface from being exposed to the external atmosphere (which is generally the atmospheric air).

### <Configuration with Substrate provided on Back electrode 13 opposite to Transparent Electrode 11>

The back electrode 13 may be provided on a substrate. As the substrate for the back electrode 13, materials equivalent to those for the transparent electrode 15 may be used, and in addition, a metallic substrate and a substrate having a supporting member formed thereon a metallic foil may also be used because no light may be extracted from the side of the back electrode 13. In a case where a substrate is provided on the back substrate 13, and no substrate is provided on the transparent substrate 15, a top-emission type light emitting device is obtained.

### <Configuration with Transparent Back conductor 122>

The back conductor 122 may configured to be transparent. In this configuration, particularly in a case where the organic layer 121 has a single layer structure, the back conductor 122 may be in contact with the back electrode 13 and may be in contact with the transparent electrode 11, whereby the disposing step of the organic EL cells 12 can be significantly simplified.

In a case where the configuration is employed, and the back electrode 13 is transparent, such a device can be provided that light can be extracted from both sides of the device.

### <Configuration with Inorganic Layer instead of Organic Layer 121>

An inorganic layer i.e., an inorganic EL light emitting device may be used instead of the organic layer 121. An inorganic EL cell may have such a structure that an inorganic layer containing an inorganic luminescent material is held by insulating layers, i.e., the electrodes on both sides of the inorganic layer are symmetric with respect to the inorganic layer. Therefore, in a case where the back conductor 122 is transparent as having been described, the back conductor 122 may be disposed to be in contact with the back electrode 13, and the back conductor 122 may be disposed to be in contact with the transparent electrode 11. In other words, the transparent conductor 120 and the back conductor 122 may not be distinguished from each other. Therefore, the disposing step of the inorganic EL cells 12 can be significantly simplified.

### <Configuration with Chassis having Curved Shape>

As shown in Fig. 2, the transparent electrode 11 and the back electrode 13 may not be formed in a flat plane but may be formed in curved shapes.

It has been difficult in the ordinary production process of an organic EL light emitting device that an organic layer or the like is uniformly formed on a curved electrode, and thus other organic EL elements than those having a flat shape are substantially difficult to be produced. In this embodiment of the invention, however, a light emitting device having a curved shape as shown in Fig. 2 can be produced since the light emitting device is constituted by arranging plural organic EL cells 12.

### <Configuration with Diffusion film provided on Light Emission Side of Organic Layer 121>

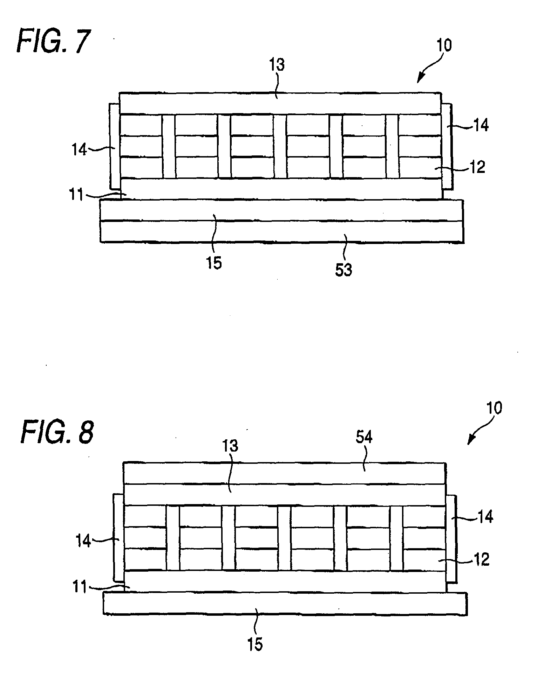

As shown in Fig. 7, a diffusion film 53 as a light diffusion member may be provided on the light emission side of the organic layer 121, in general, on the light emission side of the transparent electrode 11. According to the configuration, the emission characteristics of emitted light, such as brightness, can be further uniformized.

The transparent electrode 11 or the transparent substrate 15 may be formed by a material that includes the diffusion member that diffuses light emitted from the organic EL cells 12. The transparent electrode 11 or the transparent substrate 15 may be formed thereon with a minute bump pattern that diffuses light emitted from the organic EL cells 12. According to the above configuration, the organic EL light emitting device 10 can be made thinner than the configuration provided with the diffusion film.

### <Configuration with Light Diffusion Member provided in Chassis>

The light diffusion member (or a light scattering member) may be provided within the chassis. According to the configuration, light that cannot be incident on the transparent electrode 11, such as light emitted from the organic layer 121 to the direction toward the sealing member 14 (the in-plane direction of the organic layer), can be changed in traveling direction thereof, whereby a part or the whole of the light can be incident on the transparent electrode 11 and can be emitted to the exterior of the device through the transparent substrate 15. Accordingly, the light extraction efficiency can be improved.

In a case where a supporting member is provided between the transparent electrode 11 and the back electrode 13 as having been described, the light diffusing function (or the light scattering function) may be rendered to the supporting member.

### <Configuration with Retaining member for retaining Organic EL Cells 12 provided on Transparent Electrode 11 and/or Back electrode 13>

A member for retaining the organic EL cells 12 (retaining member) may be provided on the transparent electrode 11 and/or the back electrode 13.

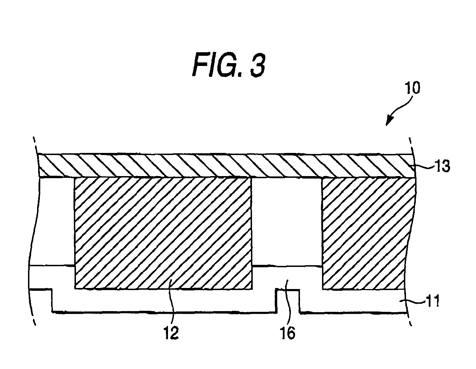

For example, as shown in Fig. 3, a protrusion 16 for retaining the organic EL cell 12 is provided on the transparent electrode 11, and the organic EL cell 12 is disposed on the protrusion 16, whereby the organic EL cell 12 can be disposed at a prescribed position on the transparent electrode 11.

It is also possible that the organic EL cells 12 are fixed at prescribed positions by a magnetic force according to the procedures having been described, and the organic EL cells 12 are fixed by retaining member, such as an adhesive. In a case where an adhesive agent is used as the retaining member, the adhesive agent is necessarily to have an electroconductive characteristic. It is further possible that the organic EL cells 12 are fixed at prescribed positions on the electrode substrate by using a binder resin containing the organic EL cells 12 and electroconductive particles having a thickness sufficiently smaller than the organic EL cells 12. The use of the electroconductive particles ensures the electric contact between the electrodes and the conductors and substantially eliminates short circuit between the transparent electrode 11 and the back electrode 13.

### <Configuration with Auxiliary Electrode provided on Transparent Electrode 11 and/or Back electrode 13>

As shown in Fig. 8, an auxiliary electrode 54 may be provided on the transparent electrode 11 and/or the back electrode 13. The auxiliary electrode is provided to be in electrically contact with the anode and/or the cathode, and is made of a material having a volume electrical resistivity that is lower than that of the electrode connected thereto. The auxiliary electrode formed with such a material can reduce the volume resistivity of the total electrode including the auxiliary electrode, whereby the maximum difference of electric current densities flowing at positions constituting the organic layer 121 can be made smaller than the case where no auxiliary electrode is provided.

Examples of a material for forming the auxiliary electrode include tungsten (W), aluminum (Al), copper (Cu), silver (Ag), molybdenum (Mo), tantalum (Ta), gold (Au), chromium (Cr), titanium (Ti), neodymium (Nd) and alloys thereof.

Specific examples of the alloys include Mo-W, Ta-W, Ta-Mo, Al-Ta, Al-Ti, Al-Nd and Al-Zr. Examples of the auxiliary electrode also include compounds of a metal and silicon, and preferably TiSi2, ZrSi2, HfSi2, VSi2, NbSi2, TaSi2, CrSi2, WSi2, CoSi2, NiSi2, PtSi and Pd2Si. A configuration obtained by accumulating the metals and the silicon compounds may also be used.

The auxiliary electrode may be a single layer film formed with the aforementioned materials and is preferably a multi-layer film formed with two or more kinds of the materials for improving the stability of the film. The multi-layer film may be formed by using the aforementioned metals or alloys thereof. Examples of a three-layer film include a combination of a Ta layer, a Cu layer and a Ta layer, and a combination of a Ta layer, an Al layer and a Ta layer, and examples of a two-layer film include combinations of an Al layer and a Ta layer, a Cr layer and an Au layer, a Cr layer and an Al layer, and an Al layer and an Mo layer.

The stability of the film referred herein means such properties that the film maintains a low volume resistivity and is resistant to corrosion with a solution used upon etching. For example, in a case where the auxiliary electrode is formed with Cu or Ag, there are some cases where the auxiliary electrode is liable to be corroded although the volume resistivity thereof is low. In these cases, a film of a metal excellent in corrosion resistance, such as Ta, Cr and Mo, may be accumulated on one or both of the upper surface and the lower surface of the metallic film formed with Cu or Ag, so as to improve the stability of the auxiliary electrode.

In general, the thickness of the auxiliary electrode is preferably from 100 nm to several tens micrometers, and particularly preferably from 200 nm to 5 µm.

This is because in a case where the thickness is less than 100 nm, the resistance value thereof is increased, which is not preferred as the auxiliary electrode, and in a case where the thickness exceeds several tens of micrometers, the auxiliary electrode is difficult to be flattened to bring about such a possibility that defects are caused in the organic EL light emitting device 10.

The width of the auxiliary electrode is preferably from 2 µm to 1,000 µm, and more preferably from 5 µm to 300 µm.

This is because in a case where the width is less than 2 µm, there are some cases where the resistance of the auxiliary electrode is increased, and in a case where the width exceeds 1,000 µm, there are some cases where the auxiliary electrode hinders extraction of light to the exterior.

### <Configuration with Organic EL Cells 12 not disposed all over Chassis>

It is not necessary that the organic EL cells 12 are disposed all over the chassis. For example, the organic EL cells 12 may be disposed at prescribed positions on the transparent electrode 11 to produce a light emitting device other than an overall light emitting device (for example, a device displaying symbols or figures). In a case where the device of this type is produced, it is necessary that the organic EL cells 12 are fixed to the prescribed positions on the transparent electrode 11 upon use, and therefore, the retaining member having been described is preferably used.

Although the present invention has been shown and described with reference to specific preferred embodiments, various changes and modifications will be apparent to those skilled in the art from the teachings herein. Such changes and modifications as are obvious are deemed to come within the spirit, scope and contemplation of the invention as defined in the appended claims.

A light emitting device includes: a plurality of luminescent cells each having substantially same thickness and including a first and a second conductive layers having conductive characteristic and a light emitting layer being sandwiched by the first and the second conductive layers and including a luminescent material that emits light when a voltage is applied; a first electrode substrate being contacted with the first conductive layer of each of the luminescent cells to be electrically connected therewith; a second electrode substrate being contacted with the second conductive layer of each of the luminescent cells to be electrically connected therewith; and a sealing member that seals the luminescent cells within a space formed between the first and the second electrode substratess. The first electrode substrate and the first conductive layer are transparent with respect to the light emitted from the light emitting layer.

## Claims

1. A light emitting device comprising:
a plurality of luminescent cells each having substantially same thickness and including a first and a second conductive layers having conductive characteristic and a light emitting layer being sandwiched by the first and the second conductive layers and including a luminescent material that emits light when a voltage is applied;
a first electrode substrate being contacted with the first conductive layer of each of the luminescent cells to be electrically connected therewith;
a second electrode substrate being contacted with the second conductive layer of each of the luminescent cells to be electrically connected therewith; and
a sealing member that seals the luminescent cells within a space formed between the first and the second electrode substrates,
wherein the first electrode substrate and the first conductive layer of each of the luminescent cells are transparent with respect to the light emitted from the light emitting layer.

2. The light emitting device according to claim 1, wherein the second electrode substrate and the second conductive layer of each of the luminescent cells are transparent with respect to the light emitted from the light emitting layer.

3. The light emitting device according to either one of claims 1 and 2, further comprising a retaining member that retains each of the luminescent cells and is disposed on at least one of the first and the second electrode substrates.

4. The light emitting device according to claim 3, wherein the retaining member is a protrusion formed on at least one of the first and the second electrode substrates.

5. The light emitting device according to any one of claims 1 through 4, wherein at least one of the first and the second electrode substrates has non-magnetic characteristic, and
wherein the luminescent cells have magnetic characteristic.

6. The light emitting device according to claim 5, wherein both of the first and the second electrode substrates has non-magnetic characteristic.

7. The light emitting device according to either of claims 5 and 6, wherein at least one of the first and the second conductive layer has magnetic characteristic.

8. The light emitting device according to any one of claims 5 through 7, wherein each of the luminescent cells further includes a magnetic layer that has magnetic characteristic.

9. The light emitting device according to any one of claims 1 through 8, wherein the luminescent material is an organic luminescent material.

10. The light emitting device according to any one of claims 1 through 8, wherein the luminescent material is an inorganic luminescent material.

11. The light emitting device according to any one of claims 1 through 10, further comprising a reinforcement substrate that has a predetermined rigidity and is provided on one of the first and the second electrode substrates.

12. The light emitting device according to any one of claims 1 through 11, further comprising a moisture absorbent provided in the space disposed between the first and the second electrode substrates.

13. The light emitting device according to any one of claims 1 through 12, wherein a gas that is inert to the luminescent cells is filled into the space disposed between the first and the second electrode substrates.

14. The light emitting device according to any one of claims 1 through 13, wherein the first and the second electrode substrates are formed in curved shapes.

15. The light emitting device according to any one of claims 1 through 14, further comprising a light diffusion member that diffuses light emitted from the light emitting layer.

16. The light emitting device according to claim 15, wherein the light diffusion member is a diffusion film.

17. The light emitting device according to claim 16, wherein the diffusion film is disposed on the first electrode substrate at a side opposite to the luminescent cells.

18. The light emitting device according to claim 15, wherein the light diffusion member is included in the first electrode substrate.

19. The light emitting device according to any one of claims 1 through 18, wherein the first electrode substrate is formed thereon with a minute bump pattern that diffuses light emitted from the light emitting layer.

20. The light emitting device according to any one of claims 1 through 19, further comprising an auxiliary electrode provided on and electrically connected to at least one of the first and the second electrode substrates, the auxiliary electrode made of a material having a volume electrical resistivity that is lower than a volume electrical resistivity of the electrode substrate that is electrically connected thereto.

21. The light emitting device according to any one of claims 1 through 20, further comprising a supporting member provided between the first and the second electrode substrates and assures a distance between the first and the second electrode substrates.

22. The light emitting device according to claim 21, wherein the supporting member diffuses light emitted from the light emitting layer.

23. A method for producing a light emitting device, the method comprising:
producing a plurality of luminescent cells each having substantially same thickness and including a first and a second conductive layers having conductive characteristic and a light emitting layer being sandwiched by the first and the second conductive layers and including a luminescent material that emits light when a voltage is applied;
arranging each of the luminescent cells on a first electrode substrate in a manner that the first conductive layer of each of the luminescent cells contacts with the first electrode substrate to be electrically connected therewith;
disposing a second electrode on the luminescent cells in a manner that the second electrode contacts with the second conductive layer of each of the luminescent cells to be electrically connected therewith; and
sealing the luminescent cells within a space formed between the first and the second electrode substrates,
wherein the first electrode substrate and the first conductive layer of each of the luminescent cells are transparent with respect to the light emitted from the light emitting layer.

24. A method for producing a light emitting device, the method comprising:
producing a plurality of luminescent cells each having substantially same thickness and including a first and a second conductive layers having conductive characteristic and a light emitting layer being sandwiched by the first and the second conductive layers and including a luminescent material that emits light when a voltage is applied;
disposing a first and a second electrode substrates with a distance that substantially equals to the thickness of the luminescent cells to form a space therebetween;
inserting the luminescent cells into the space in a manner that the first and the second conductive layers of each of the luminescent cells are respectively contacted with the first and the second electrode substrates to be electrically connected therewith, respectively; and
sealing the luminescent cells within the space formed between the first and the second electrode substrates,
wherein the first electrode substrate and the first conductive layer of each of the luminescent cells are transparent with respect to the light emitted from the light emitting layer.

25. The method according to either one of claims 23 and 24, further comprising providing a retaining member that retains each of the luminescent cells on the first electrode substrate,
wherein in arranging the luminescent cells on the first electrode substrate, each of the luminescent cells are arranged to be retained by the retaining member.

26. The method according to claim 25, wherein the retaining member is a protrusion formed on the first electrode substrate.

27. The method according to any one of claims 23 through 26, wherein at least one of the first and the second electrode substrates has non-magnetic characteristic, and the luminescent cells have magnetic characteristic, and
wherein in arranging the luminescent cells on the first electrode substrate, each of the luminescent cells are arranged by use of a magnetic force.

28. The method according to any one of claims 23 through 27, wherein the step of producing the luminescent cells includes:
producing a luminescent cell precursor having the first and the second conductive layers and the light emitting layer; and
dividing the luminescent cell precursor into each of the luminescent cells by cutting the luminescent cell precursor in a thickness direction thereof.

29. The method according to claim 28, wherein in dividing the luminescent cell precursor, a region having a prescribed quality in the luminescent cell precursor is cut.

30. The method according to any one of claims 23 through 29, wherein the luminescent material is an organic luminescent material.

31. The method according to any one of claims 23 through 30, wherein the luminescent material is an inorganic luminescent material.
